# FASCICULE DE BREVET EUROPEEN

(11) **EP 0 308 296 B1**
(45) Date de publication et mention de la délivrance du brevet: **16.02.1994**
(21) Numéro de dépôt: 88402237.7
(22) Date de dépôt: 06.09.1988
(51) Int. Cl.: H05K 7/20

(54) **Circuit imprimé équipé d'un drain thermique**
Mit einer Wärmeabfuhrvorrichtung versehene gedruckte Schaltung
Printed circuit comprising a heat sink

(30) Priorité: 16.09.1987 FR 8712805
(43) Date de publication de la demande: 22.03.1989
(73) Titulaire: TELEMECANIQUE, 92504 Rueil Malmaison Cedex (FR)
(72) Inventeur: Gohl, Pierre, F-06480 La Colle S/Loup (FR); Llabres, Raymond, F-06700 Saint Laurent du Var (FR); Malgouires, Pascal, F-06150 Cannes La Bocca (FR)
(74) Mandataire: de Saint-Palais, Arnaud Marie

(56) Documents cités:
- DE-A- 2 228 345
- FR-A- 2 560 731
- GB-A- 2 126 014
- US-A- 4 254 447

## Description

La présente invention concerne une carte de circuit imprimé portant notamment des boîtiers de composants implantés et fixés par soudure, ainsi que des moyens de dissipation de la chaleur dégagée par les boîtiers.

Une telle carte présente :
- une face de montage pour les boîtiers,
- une face de soudure des boîtiers,
- des pistes conductrices prévues sur la face de montage et sur la face de soudure,
- des trous reliant entre elles des pistes de l'une et l'autre face, les boîtiers étant munis de pattes de connexion insérées dans les trous.

Un dissipateur thermique est en outre monté sur la carte pour dissiper la chaleur dégagée par les boîtiers de composants.

Pour éviter les problèmes de rattrapage de jeu rencontrés avec les dissipateurs habituellement posés directement sur les boîtiers, il est prévu un chemin de liaison thermique pour relier les boîtiers au dissipateur.

On constate en pratique que les composants électroniques actuels du marché implantés sur une carte imprimée supportent des températures plus élevées que la carte. Il est donc fondamental d'améliorer l'efficacité de l'évacuation calorifique permise par le dissipateur et par le chemin thermique qui relie les boîtiers à ce dissipateur, si l'on veut que la température de la carte reste inférieure à une valeur donnée, par exemple typiquement de l'ordre de 105°C.

Il est connu d'après le brevet FR - 2 560 731 de prévoir entre un boîtier de composant et la carte qui porte celui-ci une plaquette en cuivre formant un shunt thermique et susceptible de s'étendre jusqu'au dissipateur. Une liaison thermique par conduction est établie entre la plaquette et le boîtier au moyen d'une lamelle en céramique plastique. La réalisation d'un tel système de refroidissement est manifestement compliquée.

Il est connu par ailleurs, d'après le brevet US-A-4 254 447, de réaliser le dissipateur sous la forme d'une pièce métallique munie de pattes implantées dans des trous de la carte au voisinage immédiat des pattes d'un boîtier, cette pièce étant fixée à la carte par passage à la vague et de prévoir des éléments métalliques de transfert de la chaleur entre le boîtier et le dissipateur thermique.

Suivant ledit brevet, lesdits éléments comprennent un conducteur de chaleur muni de pattes logées dans des fentes du circuit imprimé et sur lequel est monté le composant électronique.

Cette solution n'est utilisable que dans le cas où le composant électronique comporte de tels conducteurs thermiques incorporés à son enveloppe isolante.

L'invention a en particulier pour but de réaliser un dispositif de refroidissement efficace sur une carte du type précédemment décrit, tout en permettant d'en simplifier le processus de réalisation, notamment sans compliquer le processus général de fabrication de la carte et sans exiger l'emploi de composants spéciaux.

Elle propose une carte à circuit imprimé portant des boîtiers de composants électroniques fixés par soudure et présentant :
- une face de montage pour les boîtiers,
- une face de soudure des boîtiers,
- des pistes conductrices prévues sur la face de montage et sur la face de soudure,
- des trous prévus pour loger des pattes de connexion des boîtiers et pour établir une liaison électrique entre l'une et l'autre face,
- un dissipateur thermique constitué par une pièce métallique munie de pattes implantées dans des trous de la carte au voisinage immédiat des pattes des boîtiers, cette pièce étant fixée à la carte par passage à la vague, et
- des éléments métalliques de transfert de la chaleur entre les boîtiers et le dissipateur thermique.

Selon l'invention, ce dispositif est caractérisé en ce que lesdits éléments métalliques comprennent deux plages métalliques de drainage thermique dont l'une forme un chemin d'adduction thermique entre le boîtier respectif et le dissipateur implanté, qui sont formées respectivement sur la face de montage et sur la face de soudure de la carte et qui s'étendent jusqu'aux métallisations des trous associés aux pattes du dissipateur, la première de ces deux plages recouvrant une partie de la zone de la face de montage sous-jacente à un boîtier et étant séparée de ce boîtier par une lame d'air, de manière à recueillir la chaleur rayonnée par le ventre dudit boîtier.

Pour réduire les contraintes exercées sur la carte après le passage à la vague, on peut avantageusement prévoir sur une carte portant plusieurs boîtiers, au lieu d'un seul dissipateur, plusieurs dissipateurs dont chacun est associé à un ou plusieurs boîtiers.

La présence d'une lame d'air permet de s'affranchir des difficultés de positionnement du boîtier sur la plage. Une seconde plage de drainage peut aussi être prévue sur la face de soudure.

La plage de drainage s'étend de préférence, d'une part, jusqu'à un trou prévu pour une patte du boîtier, assurant de préférence un drainage thermique privilégié, d'autre part, jusqu'à au moins un trou prévu pour une patte du dissipateur.

La plage de drainage est avantageusement une couche métallique obtenue et revêtue d'une couche passivante, par exemple en vernis isolant, par les mêmes opérations de masquage, d'attaque et de revêtement isolant qui permettent de réaliser les pistes d'interconnexion. Pour ce qui concerne la plage de drainage située du côté de la face soudure, cette plage a également une surface assez grande pour assurer une fonction de répartition ou d'homogénéisation thermique visant à éviter la création de points chauds sur la carte et elle est de préférence suffisamment épaissie par une couche d'étamage consécutive au passage à la vague de la face soudure de la carte.

D'autres avantages et caractéristiques de l'invention apparaîtront à la lecture de la description qui suit d'un mode de réalisation préféré, en référence aux dessins annexés :
La figure 1 montre en coupe schématique une partie d'une carte à circuit imprimé conforme à l'invention ;
La figure 2 est une vue de côté, en coupe partielle, selon la ligne II-II de la figure 1 ;
La figure 3 représente à plus grande échelle le détail A de la figure 2 ;
La figure 4 est une vue en perspective éclatée de la carte selon l'invention ;
Les figures 5 et 6 sont respectivement une vue de dessus et une vue de dessous d'une partie de la carte au voisinage d'un boîtier.

La carte B à circuit imprimé illustrée sur les figures est présentement une plaque en matériau isolant 10 revêtue de cuivre sur ses deux faces, à savoir : une face 11 de montage pour des composants électroniques C, notamment à double rangée de pattes DIL, et une face 12 de soudure pour ces composants.

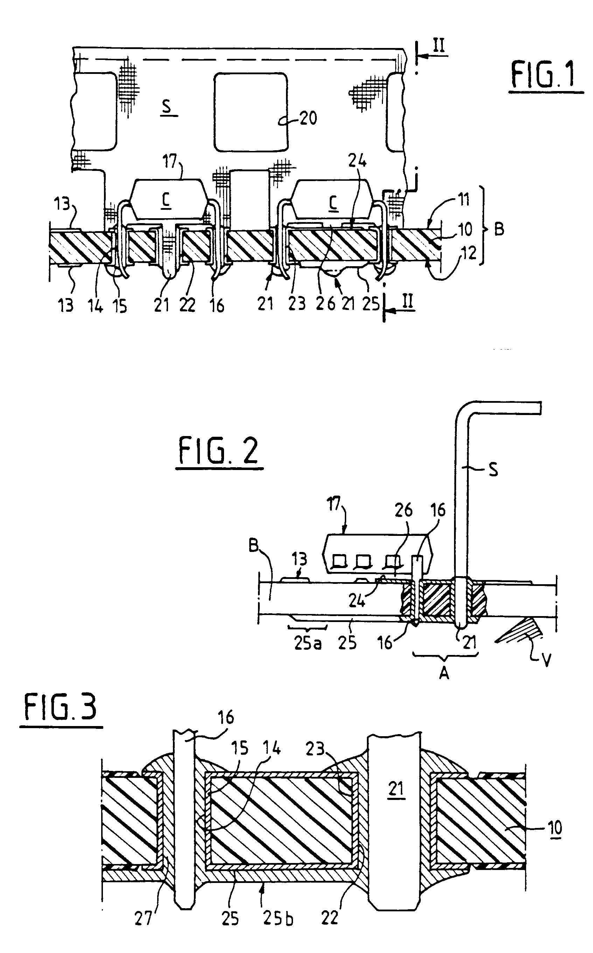

Les faces 11 et 12 portent des pistes d'interconnexion 13 obtenues de manière classique par attaque sélective du revêtement de cuivre. Des trous 14 percés dans la carte et revêtus d'une métallisation 15 sont prévus pour loger des pattes 16 de connexion des boîtiers 17 des composants C. Ceux-ci sont implantés manuellement ou automatiquement sur la carte B et sont fixés à celle-ci par passage d'une vague de soudure V sous la face 12 (voir figure 2).

Selon l'invention, un dissipateur thermique S est implanté sur la carte et est thermiquement couplé à un ou plusieurs boîtiers via au moins une plage métallique de drainage thermique.

Le dissipateur S est constitué par une pièce métallique, par exemple en cuivre étamé ; cette pièce est en forme de L munie d'ajours 20 pour permettre le passage d'air de refroidissement et de pattes 21 découpées, logées dans des trous 22 de la carte. Les trous 22 sont revêtus d'une métallisation 23 ; ils sont cylindriques et de diamètre plus grand que celui des trous 14 réservés aux pattes 16 des boîtiers, les pattes 21 ayant elles-mêmes une section supérieure à celle des pattes 16. Sur la coupe de la figure 1, la patte centrale 21 du dissipateur a été représentée pour illustrer le dispositif, bien qu'étant décalée frontalement par rapport aux pattes 16 comme l'indique la figure 2. D'autre part, seule l'une des pattes 16 du boîtier a été dessinée sur la figure 2.

Après avoir été implanté sur la carte, le dissipateur S est fixé sur celle-ci par l'opération de passage à la vague V qui permet de fixer les composants C (figure 2). Au lieu d'être formé d'une pièce découpée, le dissipateur pourrait être formé d'une pièce moulée.

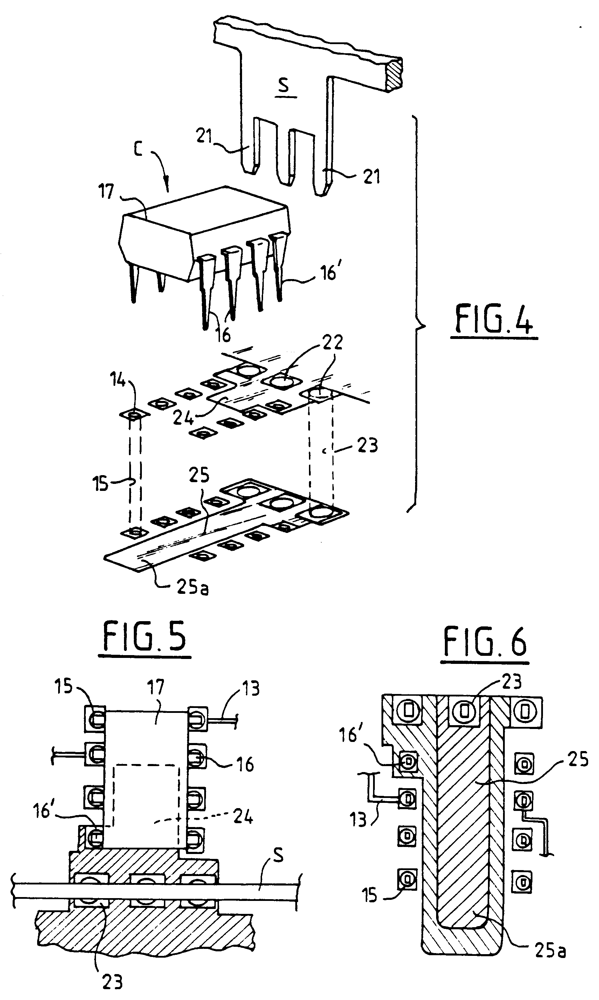

Deux plages métalliques 24, 25 de drainage thermique sont localisées respectivement sur la face de montage 11 et sur la face de soudure 12 de la carte. La plage 24 recouvre une partie de la zone de la face 11 sous-jacente au boîtier 17 (voir figures 2, 4 et 5), en étant séparée du boîtier par une lame d'air 26 (voir figure 1), de manière à recueillir la chaleur rayonnée par le ventre du boîtier.

La plage 25 recouvre la zone de la face 12 sous-jacente au boîtier et dépasse en 25a (voir figures 2, 4 et 6) de cette zone pour assurer une bonne répartition du flux thermique sur la surface de la carte, afin d'éviter la création de points chauds sur celle-ci.

Il convient de noter qu'au moins une patte 16' du boîtier 17 est reliée par conduction, d'une part, à la plage 24, d'autre part, à la plage 25. Cette patte 16' est de préférence une patte de dissipation thermique privilégiée du composant, par exemple solidaire de l'armature (lead frame) de la puce contenue dans le boîtier.

La liaison de la patte 16' avec la plage 24 s'effectue grâce à la remontée de soudure 27 occupant le trou 14 et à la métallisation 15 de celui-ci qui est elle-même en contact avec la plage 24. La liaison de la patte 16' avec la plage 25 s'effectue au moyen de la soudure 27 et de la métallisation 15 qui est en contact avec la plage 25 (voir figure 3).

Les plages 24 et 25 s'étendent jusqu'aux métallisations 23 des trous 22 associés aux pattes 21 du dissipateur S. Comme on le voit sur la figure 3, la plage 25 est épaissie par une couche métallique 25b, notamment d'étain, par passage à la vague, ce qui permet de lui conférer une section suffisante et d'accentuer sa fonction de répartition thermique.

Dans le présent exemple de réalisation, la carte présente plusieurs dissipateurs S dont chacun est associé à plusieurs composants C alignés sur la carte. A chaque composant C correspondent trois pattes 21 de drainage du dissipateur (figures 1 et 4 - 6). Les pattes 21 du dissipateur sont implantées au voisinage immédiat des pattes 16 des composants, en étant alignées perpendiculairement à l'alignement des pattes 16.

Il importe de remarquer que la plage métallique de drain 24, 25 est obtenue par des étapes de masquage et d'attaque sélective, puis revêtue d'une couche passivante, simultanément à l'obtention et de revêtement passivant des pistes d'interconnexion.

## Revendications

1. Carte à circuit imprimé portant des boîtiers (17) de composants électroniques fixés par soudure et présentant :
- une face (11) de montage pour les boîtiers,
- une face (12) de soudure des boîtiers,
- des pistes conductrices (13) prévues sur la face de montage (11) et sur la face de soudure (12),
- des trous (14) prévus pour loger des pattes (16) de connexion des boîtiers (17) et pour établir une liaison électrique entre l'une et l'autre face,
- un dissipateur thermique (S) constitué par une pièce métallique munie de pattes (21) implantées dans des trous (22) de la carte au voisinage immédiat des pattes (16) des boîtiers (17), cette pièce étant fixée à la carte (B) par passage à la vague, et
- des éléments métalliques de transfert de la chaleur entre les boîtiers (17) et le dissipateur thermique (S), caractérisée en ce que lesdits éléments métalliques comprennent deux plages métalliques (24, 25) de drainage thermique dont l'une forme un chemin d'adduction thermique entre le boîtier respectif et le dissipateur implanté (S), ces deux plages métalliques étant formées respectivement sur la face de montage (11) et sur la face de soudure (12) de la carte (B) et s'étendant jusqu'aux métallisations (23) des trous (22) associés aux pattes (21) du dissipateur (S), la première de ces deux plages (24) recouvrant une partie de la zone de la face de montage (11) sous-jacente à un boîtier (17) et étant séparée de ce boîtier (17) par une lame d'air (26), de manière à recueillir la chaleur rayonnée par le ventre dudit boîtier (17).

2. Carte à circuit imprimé selon la revendication 1,
caracterisée par le fait que le dissipateur implanté (S) présente plusieurs pattes (21) associées à un même boîtier (17) et alignées dans une direction perpendiculaire à l'alignement des pattes (16) des boîtiers (17).

3. Carte à circuit imprimé selon l'une des revendications 1 et 2,
caractérisée en ce que ladite seconde plage s'étend, d'une part, jusqu'à un trou (14) prévu pour l'une des pattes (16') du boîtier (17) qui assure un drainage thermique privilégié de celui-ci, d'autre part, jusqu'à au moins un trou (22) prévu pour une patte (21) du dissipateur (S).

4. Carte à circuit imprimé selon la revendication 1 ou 3,
caractérisée par le fait que chaque plage métallique (24, 25) est obtenue et revêtue d'une couche passivante simultanément à l'obtention et au revêtement passivant des pistes d'interconnexion.

5. Carte à circuit imprimé selon la revendication 3,
caractérisée par le fait que la plage métallique (25) située du côté de la face de soudure (12) est épaissie par une couche métallique (25b) obtenue par passage à la vague de la face de soudure et présente une surface et une section suffisantes pour répartir le flux thermique provenant du boîtier respectif.

## Claims

1. A printed circuit card carrying electronic component boxes (17) fixed by welding and presenting :
- a mounting face (11) for the boxes,
- a welding face (12) of the boxes,
- conductive tracks (13) provided on the mounting face (11) and on the welding face (12),
- holes (14) provided for inserting clips (16) for connecting the boxes (17) and for setting up an electric connection between the two faces,
- a thermal dissipator (S) formed by a metallic piece provided with lugs (21), inserted in holes (22) of the card in close vicinity of the clips (16) of the boxes (17), said piece being fixed to the card (B) by wave passage, and
- metallic elements for heat transfer between the boxes (17) and the thermal dissipator (S),
characterized in that said metallic elements comprise two metallic thermal drainage areas (24, 25), one of which forms a thermal adduction path between the respective box and the positioned dissipator (S), said two metallic areas being respectively formed on the mounting face (11) and on the welding face (12) of the card (B) and extending up to the metallizations (23) of the holes (22) associated with the lugs (21) of the dissipator (S), the first of said two areas (24) covering part of the region of the mounting face (11) which underlies a box (17) and being separated from said box (17) by an air blade (26) so as to collect the heat radiated by the bulge of said box (17).

2. A printed circuit card as claimed in claim 1,
characterized in that the positioned dissipator (S) presents several lugs (21) associated to one and the same box (17) and aligned in a right-angle direction with respect to the alignment of the clips (16) of the boxes (17).

3. A printed circuit card according to one of claims 1 and 2,
characterized in that said second area extends on the one hand up to a hole (14) provided for one of the clips (16') of the box (17) which effects a privileged thermal drainage of same, on the other hand, to at least one hole (22) provided for a lug (21) of the dissipator (S).

4. A printed circuit card as claimed in claim 1 or 3,
characterized in that each drainage metallic area (24, 25) is obtained and coated with a passivating layer, simultaneously with the achievement and the passivating coating of the interconnection tracks.

5. A printed circuit as claimed in claim 3,
characterized in that the metallic area (25) located on the welding face (12) side is thickened by a metallic layer (25b) obtained by wave passage of the welding face and presents a surface and cross-section which are sufficient for distributing the thermal flux coming from the respective box.

## Patentansprüche

1. Druckschaltungskarte, die durch Schweißung befestigte Gehäuse (17) elektronischer Bauteile trägt und aufweist:
- eine Fläche (11) für die Montage der Gehäuse,
- eine Fläche (12) zur Schweißung der Gehäuse,
- Leiterbahnen (13) auf der Montagefläche (11) und auf der Schweißungsfläche (12),
- Löcher (14) zur Einführung von Verbindungslaschen (16) der Gehäuse (17) und zur Herstellung einer elektrischen Verbindung zwischen der einen und der anderen Fläche,
- eine Wärmesenke (S) bestehend aus einem Metallteil mit Laschen (21), die in Löcher (22) der Karte in direkter Nähe der Laschen (16) der Gehäuse (17) eingesetzt sind, wobei dieses Teil an der Karte (B) durch Schwall-Löten befestigt wird, und
- Metallelemente zur Wärmeübertragung zwischen den Gehäusen (17) und der Wärmesenke (S), dadurch gekennzeichnet, daß diese Metallelemente zwei Metallbereiche (24, 25) zur Wärmeableitung aufweisen, von denen einer einen Wärmezufuhrweg zwischen dem jeweiligen Gehäuse und der eingesetzten Wärmesenke (S) bildet, wobei diese beiden Metallbereiche je auf der Montagefläche (11) bzw. auf der Schweißungsfläche (12) der Karte (B) ausgebildet sind und sich bis zu den Metallisierungen (23) der den Laschen (21) der Wärmesenke (S) zugeordneten Löcher (22) erstrecken, wobei der erste dieser beiden Bereiche (24) einen Teil der Zone der Montagefläche (11) unterhalb eines Gehäuses (17) bedeckt und von diesem Gehäuse (17) durch einen Luftspalt (26) getrennt ist, um die von der Unterseite dieses Gehäuses (17) ausgestrahlte Wärme aufzunehmen.

2. Druckschaltungskarte nach Anspruch 1, dadurch gekennzeichnet, daß die eingesetzte Wärmesenke (S) mehrere Laschen (21) aufweist, die dem gleichen Gehäuse (17) zugeordnet sind und in einer Richtung senkrecht zur Ausrichtung der Laschen (16) der Gehäuse (17) fluchten.

3. Druckschaltungskarte nach einem der Ansprüche 1 und 2, dadurch gekennzeichnet, daß der zweite Bereich sich einerseits bis zu einem Loch (14), das für eine der Laschen (16') des Gehäuses (17) vorgesehen ist und eine privilegierte Wärmeableitung dieses letzteren bewirkt, und andererseits bis zu mindestens einem Loch (22) erstreckt, das für eine Lasche (21) der Wärmesenke (S) vorgesehen ist.

4. Druckschaltungskarte nach einem der Ansprüche 1 oder 3, dadurch gekennzeichnet, daß jeder Metallbereich (24, 25) gleichzeitig mit dem Erhalten und passivierenden Bedecken der Verbindungsbahnen erhalten und mit einer passivierenden Schicht bedeckt wird.

5. Druckschaltungskarte nach Anspruch 3, dadurch gekennzeichnet, daß der Metallbereich (25) auf der Seite der Schweißungsfläche (12) durch eine Metallschicht (25b) verdickt wird, die durch Schwall-Löten der Schweißungsfläche erhalten wird und eine ausreichende Oberfläche und einen ausreichenden Querschnitt aufweist, um den vom jeweiligen Gehäuse kommenden Wärmefluß zu verteilen.
